# EUROPÄISCHE PATENTSCHRIFT

(11) **EP 3 690 926 B1**
(45) Veröffentlichungstag und Bekanntmachung des Hinweises auf die Patenterteilung: **17.08.2022**
(21) Anmeldenummer: 20164844.1
(22) Anmeldetag: 29.09.2016
(51) Int. Cl.: H01L 21/67, H01L 21/687, H01L 21/18, H01L 21/20, H01L 21/683

(54) **VORRICHTUNG UND VERFAHREN ZUM BONDEN ZWEIER SUBSTRATE**
APPARATUS AND METHOD FOR BONDING OF TWO SUBSTRATES
APPAREIL ET MÉTHODE POUR LA LIAISON DE DEUX SUBSTRATS

(43) Veröffentlichungstag der Anmeldung: 05.08.2020
(62) Teilanmeldung aus: 16779031.0
(73) Patentinhaber: EV Group E. Thallner GmbH, 4782 St. Florian am Inn (AT)
(72) Erfinder: WIMPLINGER, Markus, 4782 St. Florian am Inn (AT); KURZ, Florian, 4782 St. Florian am Inn (AT); DRAGOI, Viorel, 4782 St. Florian am Inn (AT)
(74) Vertreter: Schneider, Sascha

(56) Entgegenhaltungen:
- EP-A2- 0 899 778
- WO-A1-2015/113641
- WO-A1-2016/096025
- US-A- 6 008 113
- US-A1- 2005 014 347
- US-A1- 2007 087 531
- US-A1- 2013 105 061
- US-A1- 2015 318 260
- US-B2- 7 645 682
- A Castex ET AL: "Mechanism of Edge Bonding Void Formation in Hydrophilic Direct Wafer Bonding", ECS Solid State Letters, 24. März 2013 (2013-03-24), Seiten P47-P50, XP055354178, DOI: 10.1149/2.006306ssl Gefunden im Internet: URL:http://ssl.ecsdl.org/content/2/6/P47.f ull.pdf#page=1&view=FitH [gefunden am 2017-03-14]

## Beschreibung

Im Stand der Technik werden seit mehreren Jahren Substrate durch sogenannte Bondprozesse miteinander verbunden. Insbesondere das direkte Verbinden zweier Oberflächen bei Raumtemperatur, bei der es zuerst zur Ausbildung eines sogenannten Pre-Bonds kommt, gefolgt von einem anschließenden Wärmebehandlungsschritt ist von immensem Interesse für die Halbleiterindustrie.

Diese Bondmethode ist unter dem Namen Direkt- oder Fusionsbonden bekannt. Mit Hilfe des Fusionsbondens ist man in der Lage, nach einem Ausrichtungsprozess, welcher beide Substrate zueinander ausrichtet, die Substratoberflächen sofort miteinander zu fixieren. Dabei nutzt man die Adhäsionsfähigkeiten der Oberflächen, insbesondere die Hydrophilität gezielt aus. Die Substrate werden zuerst auf eine sehr kleine Distanz angenähert. Danach erfolgt eine Krümmung des, insbesondere oberen, Substrats, sodass die beiden Substrate sich miteinander, idealerweise punktförmig, berühren. Kurz danach wird die Fixierung des, insbesondere oberen, Substrats gelöst. Durch die Gravitation und/oder eine gezielte Steuerung breitet sich vom Kontaktierungspunkt eine Bondwelle aus, die eine vollflächige Kontaktierung und damit einen vollflächigen Pre-Bond der beiden Substrate erzeugt. Während des Ausbreitungsprozesses der Bondwelle werden alle Gase vor der Bondwelle komprimiert und vor der Bondwelle hergeschoben. Das Bondinterface bleibt dabei, zumindest größtenteils, frei von Gaseinschlüssen.

Ein sehr häufig auftretendes Phänomen bei der Erzeugung von Pre-Bonds sind sogenannte Randdefekte, insbesondere Randblasen (engl.: edge voids). Bei diesen Randblasen handelt es sich um Gaseinschlüsse die entstehen, wenn das Gas auf Grund eines geänderten physikalischen Zustands verflüssigt. Die Bondwelle breitet sich dann über das verflüssigte Gas hinweg und schließt dieses lokal ein. Nach dem erzeugten Pre-Bond erfolgt eine erneute Änderung des physikalischen Zustands, bei dem es zu einer Verdampfung des vormals kondensierten Gases kommt. Diese Verdampfung führt dann lokal zu einer Zerstörung des Pre-Bonds, welche durch Ultraschallvermessung oder Infrarotvermessung eindeutig nachweisbar sind. Castex et al., Mechanism of Edge Bonding Void Formation in Hydrophilie Direct, ECS Solid State Letters, 2 (6) P47-P50 (2013*)* beschreiben sehr umfangreich, wie die Kondensation des Gases vor der Bondwelle zustande kommt.

Weitere Vorrichtungen und Verfahren zum Bonden zweier Substrate werden in den Dokumenten US2015/0318260-A1, WO2016/096025-A1 und WO2015/113641-A1 beschrieben.

Substratoberflächen sind niemals gänzlich rein. Die unterschiedlichsten Atome und Moleküle werden auf Substratoberflächen adsorbiert, wenn auch nur in einer einzelnen Monolage. Auf Grund der Tatsache, dass jede Atmosphäre einen nicht verschwindend geringen Anteil an Wasserdampf enthält, zählt Wasser zu den dominierenden Komponenten, der Substratoberflächenverunreinigung. Des Weiteren können organische Substanzen, selbst Partikel oder atomare bzw. molekulare Gase wie Sauerstoff, Stickstoff oder Helium an der Substratoberfläche anhaften. In dieser Druckschrift werden vor allem eine Anlage und Methoden aufgezeigt, um Gase, insbesondere Wasser, von der Substratoberfläche zu entfernen bzw. zu verhindern, dass sie kondensieren. Es wird daher davon ausgegangen, dass sie Substratoberfläche frei von organischen Komponenten, erst recht von Partikeln, ist.

Gase, insbesondere aber auch Gasgemische, besitzen einen, vom Druck und Temperatur abhängigen Joule-Thompson Koeffizient (JTK). Der JTK legt fest, ob ein Gas bzw. ein Gasgemisch bei einer isenthalpen Expansion eine Abkühlung oder Erwärmung erfährt. Unter einer isenthalpen Expansion versteht man den Übergang eines Gases bzw. Gasgemisches aus einem ersten, komprimierten Zustand in einen zweiten weniger komprimierten Zustand, bei dem die Enthalpie des Gases erhalten bleibt. Gase bzw. Gasgemische die einen positiven JTK besitzen weisen die Eigenschaft auf, dass sie bei einer isenthalpen Expansion abkühlen. Gase bzw. Gasgemische die einen negativen JTK besitzen weisen die Eigenschaft auf, dass sie bei einer isenthalpen Expansion erwärmen. Der zugrundeliegende physikalische Effekt ist die Anziehungs- bzw. Abstoßungsfähigkeit der Moleküle. Ziehen sich die Moleküle bei einer vorgegebenen Temperatur an, muss Arbeit geleistet, also Energie eingesetzt werden, um sie voneinander zu trennen. Diese Arbeit wird dem System entzogen, senkt damit die Geschwindigkeit der Moleküle und reduziert damit die Temperatur. Stoßen sich die Moleküle bei einer vorgegebenen Temperatur ab, wird Arbeit vom System geleistet, also Energie freigesetzt. Diese freigesetzte Energie erhöht damit die Geschwindigkeit der Moleküle und erhöht damit die Temperatur.

Die Druckschrift Castex et al., Mechanism of Edge Bonding Void Formation in Hydrophilie Direct, ECS Solid State Letters, 2 (6) P47-P50 (2013*)* beschreibt sehr genau, welche physikalischen Vorgänge sich in der Nähe des Substratrandes abspielen. Vereinfacht sei erwähnt, dass das Gas bzw. Gasgemisch beim Austritt des Substratzwischenraumes einen sehr starken Druckabfall erleidet. Auf Grund der Tatsache, dass sich der Prozess im Bruchteil einer Sekunde abspielt, kann die Energie nicht schnell genug abgeführt werden und der Prozess kann als isenthalpisch angesehen werden. Folglich entscheidet der JTK des Gases bzw. Gasgemisches darüber, ob bei der isenthalpen Expansion eine Abkühlung oder Erwärmung des Gases bzw. Gasgemisches erfolgt. Die Abkühlung des Gases bzw. Gasgemisches kann so stark sein, dass der Taupunkt des Gases bzw. Gasgemisches unterschritten wird und das Gas bzw. Gasgemisch bzw. einzelnen Komponenten des Gasgemisches kondensieren. Die Substratoberfläche dient dabei als Kristallisationskeim. Es handelt sich daher um eine heterogene Keimbildung, die eine noch niedrigere Keimbildungsenergie besitzt als eine homogene Keimbildung in der Gasphase. Dieser physikalische Vorgang der Kondensation ist zu vermeiden.

Es ist daher die Aufgabe der vorliegenden Erfindung, die Nachteile des Stands der Technik zu beseitigen und insbesondere ein verbessertes Bondergebnis zu erzielen.

Diese Aufgabe wird mit dem Gegenstand der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein.

Der Kerngedanke der Erfindung besteht darin, dass die Substratoberfläche beziehungsweise die Substratoberflächen derart erweitert werden, dass das Gas, welches beim Bondvorgang durch die Bondwelle vom Zentrum nach Außen hin verdrängt wird, sich nicht bereits schon am Rand zwischen den Substraten ausdehnt, sondern dass die Expansion des Gases erst außerhalb der beiden Substrate erfolgt. Mit anderen Worten: das Gas wird noch mit erhöhtem Druck aus dem Zwischenraum zwischen den Substraten gedrängt und der Druckabfall beziehungsweise die Expansion erfolgt erst, wenn die umgebende Erhöhung beziehungsweise die Erweiterungsoberfläche erreicht ist beziehungsweise über die Erhöhung beziehungsweise die Erweiterungsoberfläche hinweg läuft oder darüber hinaus gedrückt worden ist.

Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben.

Erfindungsgemäß weist die Vorrichtung zum Bonden einer ersten Substratoberfläche eines ersten Substrats mit einer zweiten Substratoberfläche eines zweiten Substrats auf:
- einen ersten Substrathalter zur Aufnahme des ersten Substrats,
- einen zweiten Substrathalter zur Aufnahme des zweiten Substrats,
wobei zumindest der erste Substrathalter eine erste Vertiefung mit einer Fixiereinrichtung zur Fixierung des ersten Substrats in der ersten Vertiefung sowie eine die Vertiefung zumindest teilweise umgebende Erhöhung aufweist.

Erfindungsgemäß ist weiterhin vorgesehen ein System aus einer erfindungsgemäßen Vorrichtung und dem ersten Substrat, wobei die erste Substratoberfläche in die Erhöhung übergeht.

Weiterhin erfindungsgemäß vorgesehen ist ein Verfahren zum Bonden einer ersten Substratoberfläche eines ersten Substrats mit einer zweiten Substratoberfläche eines zweiten Substrats mittels einer erfindungsgemäßen Vorrichtung, wobei ein zwischen den Substratoberflächen beim Bondvorgang angeordnetes Gas von einem Zentrum zum Rand der Substrate hin verdrängt wird, wobei die erste Substratoberfläche in die Erhöhung derart übergeht, dass eine Expansion des Gases erst außerhalb der Substrate erfolgt und/oder die Differenz p-po aus einem Druck p am Substratrand am Ende des Bondvorganges und einem Umgebungsdruck p₀ größer Null ist.

Vorteilhaft kann die Kondensation eines, zwischen den Substraten und vor der Bondwelle hergetriebenen, Gases bzw. Gasgemisches verhindert werden, sodass es nicht zur Ausbildung einer kondensierten Phase und damit nicht zur Ausbildung von Randblasen kommt. Die Substratoberflächen der Substrate werden derart erweitert, sodass vorteilhaft die für das Entstehen der Randblasen verantwortlichen physikalischen Effekte sich außerhalb der Substratoberflächen abspielen.

Der Vorteil der Erfindung besteht daher in der Reduzierung, insbesondere gänzlichen Vermeidung, von Randblasen in fusionsgebondeten Substraten.

Alle genannten erfindungsgemäßen Ausführungsformen und Prozesse können beliebig miteinander kombiniert werden, werden aber einzeln beschrieben. Bevorzugt ist es vorgesehen, dass sowohl der erste Substrathalter als auch der zweite Substrathalter eine Vertiefung mit einer Fixiereinrichtung aufweisen. Bevorzugt haben beide Substrathalter eine die Vertiefung zumindest teilweise umgebende Erhöhung.

Bevorzugt verläuft die Erhöhung beziehungsweise die Erhöhungen zumindest teilweise ringförmig um die Vertiefung herum. Die Erhöhung kann insbesondere durchgehend ringförmig um die Vertiefung herum ausgebildet sein.

Die folgenden Ausführungen sind für den ersten Substrathalter beziehungsweise einen Substrathalter erstellt. Die Aspekte beziehungsweise Ausführungsformen gelten jedoch gleichermaßen für eine erfindungsgemäße Vorrichtung, bei der beide Substrathalter mit einer Vertiefung und einer Erhöhung ausgestattet sind.

Die Erfindung sieht vor, dass die Erhöhung eine Erweiterungsoberfläche zur nahtlosen Erweiterung der ersten Substratoberfläche aufweist. Dadurch ist vorteilhaft ein besonders effizienter Übergang des Gases von der Substratoberfläche zur Erweiterungsoberfläche möglich.

Bevorzugt ist weiterhin vorgesehen, dass die Vertiefung und/oder die Erhöhung derart an das erste Substrat, insbesondere an die Form des ersten Substrats, angepasst ist/sind, dass die Substratoberfläche mit der Erweiterungsoberfläche eine im Wesentlichen durchgehende Oberfläche bildet und/oder in die Erhöhung übergeht. Dadurch ist vorteilhaft eine besonders gute Abstimmung der Vertiefung und/oder der Erhöhung mit der Substratoberfläche möglich, sodass das Gas besonders effizient weitergeleitet werden kann.

Bevorzugt ist weiterhin vorgesehen, dass die Vertiefung und/oder die Erhöhung manuell und/oder halbautomatisch und/oder automatisch derart anpassbar ist/sind, dass die Substratoberfläche mit der Erweiterungsoberfläche eine im Wesentlichen durchgehende Oberfläche bildet und/oder in die Erhöhung übergeht. Dadurch ist es vorteilhaft möglich, die Vertiefung und/oder die Erhöhung an die Substratoberfläche variabel anzupassen. Durch diese Einstellbarkeit können unterschiedliche Substrate mit der Vorrichtung bearbeitet werden. Ein Austausch der Vorrichtung ist dadurch vermeidbar.

Bevorzugt ist weiterhin vorgesehen, dass der erste Substrathalter ein äußeres Bauteil und ein im äußeren Bauteil bewegliches inneres Bauteil aufweist, wobei das äußere und/oder innere Bauteil translatorisch und/oder rotatorisch beweglich ist, wobei die Bauteile zueinander fixierbar sind. Durch die Beweglichkeit ist es vorteilhaft möglich, dass die Beladung der Vorrichtung mit dem Substrat erheblich vereinfacht werden kann. Außerdem können die Abstände zwischen den Substraten beziehungsweise zwischen den Substratoberflächen und den Erhöhungen beziehungsweise Erweiterungsoberflächen variabel eingestellt werden.

Bevorzugt ist weiterhin vorgesehen, dass der vertikale Abstand zwischen der ersten Substratoberfläche und der Erweiterungsoberfläche anpassbar ist. Dadurch ist es vorteilhaft möglich, dass der vertikale Abstand optimal einstellbar ist, sodass das Gas besonders effizient von der Substratoberfläche zur Erweiterungsoberfläche übergeht.

Bevorzugt ist weiterhin vorgesehen eine Vorrichtung, aufweisend mindestens eine Bohrung zur Evakuierung und/oder Spülung der Vertiefung, wobei bevorzugt mehrere Bohrungen symmetrisch verteilt, insbesondere im inneren Bauteil, angeordnet sind. Durch die Möglichkeit, die Vertiefung zu evakuieren und/oder zu spülen, ist es vorteilhaft möglich, dass das verdrängte Gas derart beeinflusst wird, dass der Übergang von der Substratoberfläche zur Erhöhung beziehungsweise der Erweiterungsoberfläche verbessert werden kann. Des Weiteren können die Bohrungen dazu verwendet werden, um in bzw. der Nähe der Vertiefungen, insbesondere im Übergangsbereich zwischen den Substratperipherien und der Erweiterungsoberfläche, Überdruck aufzubauen. Dieser zusätzlich erzeugte Überdruck verhindert, dass es in diesem Bereich zu einem Druckabfall bzw. zu einer Expansion des Gases bzw. des Gasgemisches kommt. Der Druck in diesem Bereich ist insbesondere größer als 1 bar, vorzugsweise größer als 2 bar, noch bevorzugter größer als 4 bar, am bevorzugtesten größer als 6 bar, am allerbevorzugtesten größer als 10 bar.

Bevorzugt ist weiterhin vorgesehen, dass die Erhöhung eine nach innen und/oder außen hin gekrümmte Erweiterungsoberfläche aufweist. Durch die Krümmung nach innen und/oder nach außen hin kann das verdrängte Gas noch weiter beeinflusst werden. Im Falle, dass sich das Volumen nach außen hin verkleinert beziehungsweise, dass die Erweiterungsoberfläche nach außen hin gekrümmt ist, wird thermodynamisch die Wirkung eines Drosselventils erreicht. Mit anderen Worten: mit der Geometrie der Erweiterungsoberfläche kann das verdrängte Gas beeinflusst werden, sodass es verdichtet oder expandiert werden kann.

Bevorzugt ist weiterhin vorgesehen, dass die Erhöhung eine nach innen und/oder außen hin in einem Winkel abgeschrägte Erweiterungsoberfläche aufweist. Im Prinzip gilt hierfür das analoge wie für die gekrümmte Erweiterungsoberfläche. Durch die Definition eines bestimmten Winkels a der Abschrägung zur Horizontalen kann eine optimale Beeinflussung des Gases erreicht werden.

### Anlagen und Substrathalter

Die in den weiteren Ausführungen genannten Substrathalter bilden jeweils eine erfindungsgemäße Vorrichtung.

Die Fixiereinrichtung umfasst insbesondere
- Mechanische Fixierungen, insbesondere
   o Klemmen
- Vakuumfixierungen, insbesondere mit
   o einzeln ansteuerbare Vakuumbahnen
   o miteinander verbundenen Vakuumbahnen
- Elektrische Fixierungen, insbesondere
   o Elektrostatische Fixierungen
- Magnetische Fixierungen
- Adhäsive Fixierungen, insbesondere
   o Gel-Pak Fixierungen
   o Fixierungen mit adhäsiven, insbesondere ansteuerbaren, Substratoberflächen.

Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Substratoberfläche des Substrathalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von Innen nach Außen durchgeführte Fixierung und/oder Loslösung eines Substrats vom Probenhalter ermöglicht. Insbesondere wird auf die Möglichkeit von Vakuumzonen aus der Druckschrift PCT/EP2016056249 verwiesen. Des Weiteren wird die Verwendung eines Substrathalters mit Nadeln (engl.: pin chuck) offenbart. Ein derartiger Substrathalter wurde ausführlich in der Druckschrift WO2015113641A1 beschrieben. Die Verwendung eines derartigen Substrathalters ist vorteilhaft, um eine möglichst geringe Kontaktfläche zwischen dem Substrat und dem Substrathalter zu ermöglichen, sodass die Kontaminierung der Substratrückseite auf ein Minimum reduziert wird bzw. sodass überhaupt keine Kontaminierung stattfindet.

Im Allgemeinen existieren für jede erfindungsgemäße Vorrichtung zwei Substrathalter. Die beiden Substrathalter sind im Allgemeinen nicht vollständig identisch, da mindestens einer der Substrathalter ein oder mehrere Verformungselemente aufweist, um eines der Substrate verformen zu können. Jeder Substrathalter wird daher im Einzelnen beschrieben.

In einer ersten erfindungsgemäßen Ausführungsform besteht die Lösung des technischen Problems darin, die Substratoberfläche durch eine Erweiterungsoberfläche nahtlos zu erweitern, sodass der Druckabfall nicht in der Nähe des Substratrandes stattfindet. Erfindungsgemäß wird daher ein Substrathalter offenbart, der, insbesondere eine dem Substrat angepasste, Vertiefung besitzt. Das Substrat wird in der Vertiefung fixiert und die Substratoberfläche bildet mit der Erweiterungsoberfläche eine mehr oder weniger durchgehende neue, erweiterte Oberfläche.

Der erste, insbesondere untere, Substrathalter besitzt eine, insbesondere an die Form des Substrates angepasste Vertiefung. Die äußere Substratperipherie des ersten Substrats besitzt einen horizontalen Abstand hu zur Innenwand einer Erhöhung des ersten Bauteils. Die Substratoberfläche des ersten Substrats besitzt einen vertikalen Abstand vu zur Erweiterungsoberfläche des ersten Bauteils. Die Fixierungen fixieren das Substrat.

Der zweite, insbesondere obere, Substrathalter besitzt eine, insbesondere an die Form des Substrates angepasste Vertiefung. Die äußere Substratperipherie des zweiten Substrats besitzt einen horizontalen Abstand ho zur Innenwand des oberen Bauteils. Die Substratoberfläche des zweiten Substrats besitzt einen vertikalen Abstand vo zur Oberfläche des oberen Bauteils. Die Fixierungen fixieren das Substrat. Zusätzlich ist mit Vorzug ein Verformungsmittel verbaut, mit welchem man das zweite Substrat verformen kann.

In einer zweiten erfindungsgemäßen Ausführungsform besteht die Lösung des technischen Problems ebenfalls darin, die Substratoberfläche durch eine Erweiterungsoberfläche nahtlos zu erweitern, sodass der Druckabfall nicht in der Nähe des Substratrandes stattfindet. Erfindungsgemäß wird aber ein Substrathalter offenbart, der, insbesondere eine dem Substrat anpassbare, Vertiefung besitzt.

Der erste, insbesondere untere, Substrathalter besteht aus mindestens zwei Bauteilen. Das erste Bauteil besitzt eine, insbesondere an die Form des Substrates anpassbare Vertiefung. Die äußere Substratperipherie des ersten Substrats besitzt einen horizontalen Abstand hu zur Innenwand des unteren Bauteils. Die Substratoberfläche des ersten Substrats besitzt einen vertikalen Abstand vu zur Oberfläche des ersten Bauteils. Die Fixierungen fixieren das Substrat.

Der zweite, insbesondere obere, Substrathalter besitzt eine, insbesondere an die Form des Substrates anpassbare Vertiefung. Die äußere Substratperipherie des zweiten Substrats besitzt einen horizontalen Abstand ho zur Innenwand des oberen Bauteils. Die Substratoberfläche des ersten Substrats besitzt einen vertikalen Abstand vo zur Ausgangsoberfläche des ersten Bauteils. Die Fixierungen fixieren das Substrat. Zusätzlich ist mit Vorzug ein Verformungsmittel verbaut, mit welchem man das zweite Substrat verformen kann.

Die Vertiefung ist insbesondere manuell und/oder halbautomatisch und/oder vollautomatisch variierbar. Insbesondere besteht der erste Substrathalter aus einem ersten äußeren Bauteil und einem zweiten, sich im äußeren Bauteil beweglichen, zweiten Bauteil. Die beiden Bauteile können zueinander translatorisch, insbesondere auch rotatorisch, bewegt werden. Die beiden Bauteile sind insbesondere auch zueinander fixierbar. Durch die Möglichkeit der relativen Verfahrbarkeit der beiden Bauteile kann die Höhenposition, insbesondere auch die rotatorische Lage, des ersten und/oder zweiten Substrats genauestens eingestellt werden. Durch die erfindungsgemäße Weiterentwicklung der Substrathalter durch mindestens zwei Bauteile können die vertikalen Abstände vu und vo dynamisch angepasst werden um optimale Bondergebnisse zu erzielen.

### Allgemeine Definition

Der erste Substrathalter kann ebenfalls über Verformungsmittel verfügen oder so konstruiert sein, dass eine Vorkrümmung des ersten Substrats durchgeführt werden kann. Derartige Vorkrümmungen können einen vorgesehenen Fusionsbond positiv beeinflussen. Eine genaue Beschreibung derartiger Verformungsmittel findet man in der Druckschrift WO2014191033A1.

Alle genannten Abstände hu, ho, vu, vo sind kleiner als 5mm, vorzugsweise kleiner als 1 mm, noch bevorzugter kleiner als 0.5 mm, am bevorzugtesten kleiner als 100 µm, am allerbevorzugtesten kleiner als 10 µm. Mit besonderem Vorzug sind die Abstände hu und ho identisch. Mit besonderem Vorzug sind die Abstände vu und vo identisch. Mit ganz besonderem Vorzug sind die Abstände hu, ho, vu, vo identisch.

Es ist technisch äußerst herausfordernd bzw. teuer, die Abstände hu, ho, vu, vo so exakt zu konstruieren, dass ein nahtloser Übergang des Gases bzw. Gasgemisches aus dem Bereich zwischen den Substraten über die Erweiterungsfläche nach außen erfolgt. Daher werden für den erfindungsgemäßen Prozess die Abstände hu, ho, vu, vo so klein wie möglich gewählt und zusätzlich für einen genügend großen Überdruck in den Vertiefungen gesorgt, dass es niemals in der Nähe der Substratperipherien zu einer Kondensation eines Gases kommt.

Der Druck in der Nähe der Substratperipherien muss daher insbesondere zu dem Zeitpunkt in dem sich die Bondwelle nähert, gleich oder zumindest ähnlich sein dem Gas- bzw. Gasgemischdruck aus dem Bereich zwischen den Substraten. Die Druckdifferenz zwischen beiden Drücken ist insbesondere kleiner als 2 bar, vorzugsweise kleiner als 1 bar, noch bevorzugter kleiner als 0.1 bar, am bevorzugtesten kleiner als 0.01 mbar, am allerbevorzugtesten kleiner als 10E-3 mbar.

Der zusätzliche Überdruck in den Vertiefungen wird insbesondere durch ein Gas bzw. Gasgemisch erzeugt, welches über die Bohrungen eines der Substrathalter geleitet wird. Insbesondere handelt es sich dabei um ein Gas bzw. Gasgemisch, welches sich bei einer isenthalpischen Expansion erwärmt, daher einen negativen JTK besitzt, da dieses Gas bzw. Gasgemisch sich ja mit dem Gas bzw. Gasgemisch aus dem Bereich zwischen den Substraten vermischt und über die Erweiterungsfläche nach Außen transportiert wird.

Sollte es auf dem Weg dorthin bereits zu einer isenthalpischen Expansion kommen, kann das eingeleitet Gas bzw. Gasgemisch durch eine Temperaturerhöhung der Kondensation anderer Gase entgegenwirken. Die Temperaturerhöhung im Bereich zwischen den Substraten sollte insbesondere so hoch sein, dass die Temperatur mehr als 0.1 °C, vorzugsweise mehr als 0.5°C, noch bevorzugter mehr als 5°C, am bevorzugtesten mehr als 10°C, am allerbevorzugtesten mehr als 20°C über der Kondensationstemperatur des Gases bzw. Gasgemisches liegt.

Alle erfindungsgemäßen Substrathalter können über Bohrungen verfügen, über die eine Evakuierung und/oder eine Spülung des Innenraums, insbesondere der Vertiefung, erfolgen können. Insbesondere sind mehrere Bohrungen denkbar, die symmetrisch in einem der Bauteile, insbesondere im ersten Bauteil, angeordnet sind. Die Anzahl der Bohrungen ist dabei 1, vorzugsweise 2, noch bevorzugter mehr als 5, am bevorzugtesten mehr als 10, am allerbevorzugtesten mehr als 25. Die Verwendung mehrerer Bohrungen ist insbesondere wichtig um eine symmetrische Evakuierung und/oder Spülung des Innenraums durchführen zu können.

Alle genannten Substrathalter, insbesondere der untere, können noch über Ladeelemente, insbesondere Ladestifte, verfügen, welche die Be- und Entladung der Substrate erleichtern. In den Zeichnungen wird auf deren Darstellung verzichtet um die Übersichtlichkeit zu erhalten.

Allen Ausführungsformen kann eine Evakuierung des Innenraums der erfindungsgemäßen Anlage vorhergehen. Insbesondere wird der Druck auf weniger als 1 bar, vorzugsweise weniger als 0.1 mbar, noch bevorzugter weniger als 10-3 mbar, am bevorzugtesten weniger als 10-5 mbar, am allerbevorzugtesten weniger als 10-7 mbar reduziert. Der Evakuierung des Innenraums geht bereits eine Entfernung einer Vielzahl von Komponenten einher, welche für den folgenden Pre-Bond Schritt zu Defekten, insbesondere dem erfindungsgemäß behandelten Kondensationen, führen können. Unabhängig von der Dauer und der Stärke der Evakuierung werden immer einige wenige, insbesondere an den Substratoberflächen adhäsiv gebundene Komponenten, insbesondere Wasser, verbleiben, die durch einen einfachen Evakuierungsschritt nicht entfernt werden können.

Des Weiteren können eine Evakuierung und eine Spülung mehrmals hintereinander ausgeführt werden, um die Qualität der Atmosphäre zu verbessern. Darunter versteht man beispielsweise das Ersetzen von Luftkomponenten mit einem Gas bzw. Gasgemisch, insbesondere einem Inertgas wie Helium, welches insbesondere einen JTK besitzt, der bei einer isenthalpen Expansion zu einer Erwärmung führt. Eine Atmosphäre wird dann als umso reiner angesehene, je höher der Anteil dieses Gases bzw. Gasgemisches ist. Die Qualität der Atmosphäre ist insbesondere größer als 50%, vorzugsweise größer als 75%, noch bevorzugter größer als 85%, am bevorzugtesten größer als 95%, am allerbevorzugtesten größer als 99%. Durchgeführt wird der Prozess insbesondere mit mindestens einem der Gase, die in einer der folgenden erwähnten erweiterten Ausführungsformen verwendet werden.

In einer weiteren Ausführungsform wird vor und/oder während und/oder nach dem Bonden der Innenraum, insbesondere die Vertiefungen mit einem Gas oder einem Gasgemisch gespült, was dafür sorgt, dass der Temperaturabfall der aus dem Substratzwischenbereich herausgedrückten, insbesondere isenthalpisch expandierenden, Gasen so gering ausfällt, vorzugsweise sogar soweit unterdrückt wird, dass es zu keiner Kondensation der Gase bzw. Gasgemische auf den Substratoberflächen kommt. Grundsätzlich kann jedes dafür geeignete Gas, insbesondere Helium, Wasserstoff und Neon, verwendet werden. Helium wird, auf Grund seiner sehr kleinen Inversionskurve, als exemplarisches Beispiel genannt.

In einer weiteren erfindungsgemäßen Ausführungsform wird ein Temperaturabfall einer isenthalpischen Expansion durch eine Beheizung des Randes, insbesondere der Erweiterungsoberfläche bewerkstelligt. Die Erweiterungsoberfläche kann dabei auf Temperaturen von mehr als 25°C, vorzugsweise mehr als 50°C, noch bevorzugter mehr als 100°C, am bevorzugtesten mehr als 150°C, am allerbevorzugtesten mehr als 200°C erwärmt werden. Die Beheizung der Erweiterungsoberfläche kann auch mit allen anderen genannten erfindungsgemäßen Aspekte kombiniert werden.

In einer weiteren erfindungsgemäßen Ausführungsform kann durch eine gezielte Wahl des Spaltes g zwischen den beiden Erweiterungsflächen des unteren und oberen Substrathalters sichergestellt werden, dass sich durch das Fortschreiten der Bondwelle und dem damit verdrängten Gas bzw. Gasgemisch ein Überdruck im Innenraum der beiden Substrathalter, insbesondere im Bereich der Vertiefungen, aufbaut. Dafür ist es notwendig, dass der Innenraum zu diesem Zeitpunkt geschlossen ist. Insbesondere müssen die Bohrungen verschlossen sein. In einer besonders bevorzugten Ausführungsform werden die Bohrungen gänzlich geschlossen bzw. sogar konstruktionstechnisch nicht realisiert, um das Volumen des Innenraums möglichst klein zu halten.

Um der Kondensation entgegen zu wirken muss die Temperatur in der Gasmischung, in der sich insbesondere das kondensierende Gas befindet, erhöht werden. Gemäß dem Inversionsdiagramm für Helium, besitzt Helium einen sehr kleinen Bereich mit positivem JTK und einen extrem großen Bereich mit einem negativen JTK. Helium besitzt daher, insbesondere unter moderaten Bedingungen, also bei ca. 298 Kelvin und im Druckbereich von 1-10 bar, welcher für das kondensierende Gas vor der isenthalpen Expansion angenommen wird, immer einen negativen JTK. Helium wird sich daher, wenn es isenthalpisch unter oben genannten Bedingungen expandiert wird, erwärmen und wirkt so der Kondensation des kondensierenden Gases entgegen. Ein weiteres exzellentes Gas für das Vorhaben wäre Wasserstoff. Die Inversionskurve für Wasserstoff liegt ebenfalls unterhalb von ca. 298 Kelvin und eignet sich daher ebenfalls für die erfindungsgemäße Verwendung als temperaturerhöhendes Gas bei isenthalpischer Expansion. Des Weiteren hat Wasserstoff reduzierende Eigenschaften im Gegensatz zum inerten Helium. Um denselben erfindungsgemäßen Effekt mit Stickstoff bei 298 Kelvin zu erzielen, müsste man das Gasgemisch auf einen Druck jenseits von 400 bar erhöhen, was technisch schwer realisierbar wäre.

In einer weiteren Ausführungsform werden die Substrate vor dem Bondprozess in einer erfindungsgemäßen Ausführungsform wärmebehandelt. Die Wärmebehandlung erfolgt dabei auf einer Heizplatte und/oder in einem Ofen, insbesondere einem Durchlaufofen. Die Wärmebehandlung hat insbesondere die Funktion der Entfernung von Gasen und/oder chemischen Resten auf der Substratoberfläche durch Energieeintragung. Vorzugsweise wird die Wärmebehandlung in einer Vakuumumgebung durchgeführt um eine erneute Adhäsion von Gasen weitestgehend zu verhindern. In einer besonders bevorzugten erfindungsgemäßen Ausführungsform werden die Substrate von einem heißen Medium, Insbesondere Fluid, überströmt. Das Überströmen der Substratoberfläche mit einem heißen Fluid hat den Vorteil, dass durch die thermische Bewegung nicht nur Moleküle von der Substratoberfläche resorbiert werden, sondern vom Fluidstrom mitgenommen, daher von der Substratoberfläche entfernt werden.

In einer weiteren Ausführungsform werden die Substrate plasmabehandelt. Die Plasmabehandlung hat vor allem den Vorteil, dass die Substratoberflächen terminiert werden. Unter Terminierung versteht man das gezielte Anbringen von Molekülen mit gewissen Eigenschaften an der Substratoberfläche. Die Substratoberfläche soll insbesondere hydrophobisiert werden, d.h. ihre Hydrophilität verlieren. Durch eine reduzierte Hydrophilität wird das Anhaften von Gasen, insbesondere polaren Gase, ganz bevorzugt von Wasserdampf, erschwert, wenn nicht gar verhindert.

In einer besonders bevorzugten Ausführungsform wird die Plasmabehandlung so durchgeführt, dass die Hydrophilität nur reduziert wird aber nicht gänzlich verloren geht. Damit erreicht man, dass weniger Wasser an der Oberfläche anhaftet.

In einer weiteren Ausführungsform werden die Substratoberflächen so modifiziert, dass sich die Bondwelle langsamer ausbreitet. Durch ein langsameres Ausbreiten der Bondwelle hat das Gas mehr Zeit zu expandieren und der Druckaufbau zwischen den Substraten dürfte erheblich reduziert werden. Mit Vorteil kann der Aspekt, dass die Bondwelle gleichmäßig über den Substratrand hinwegläuft auch dazu genutzt werden, dass keine unregelmäßigen Verzerrungen auf dem Substratrand eingebaut werden. Methoden zur Beeinflussung der Bondwellengeschwindigkeit werden explizit in der Druckschrift PCT/EP2016053268 erwähnt.

In einer weiteren Ausführungsform werden die Substratoberflächen, insbesondere nach einer Plasmabehandlung, nasschemisch gereinigt. Die nasschemische Reinigung hat vor allem die Aufgabe, die durch das Plasma aktivierten Substratoberflächen zu terminieren. Durch diesen Prozess kann die Hydrophilität und damit die Menge an adsorbiertem Wasser ebenfalls gezielt eingestellt werden.

In einer weiteren erfindungsgemäßen Ausführungsform der Vorrichtung werden Flächenvergrößerungsmittel anstatt der Substrathalter verwendet. Ziel der Flächenvergrößerungsmittel ist das Erstellen einer Hilfsvorrichtung, mit welchen in herkömmlichen Fusionsbondvorrichtungen das Verfahren zur Minimierung der Randdefekte verwendet werden kann. Unterschiedliche Flächenvergrößerungsmittel umschließen vorzugsweise jeweils eins von beiden Substraten allumfänglich am äußeren Rand und erweitern die Substratoberfläche.

Die Materialeigenschaften der Flächenvergrößerungsmittel sind auf die Biegesteifigkeiten sowie Krümmungsverhalten der Substrate so weit abgestimmt, dass die thermischen sowie mechanischen Eigenschaften als substratidentisch angesehen werden können. Insbesondere geht es darum, dass die Substrate mit einer minimalen Stufe an die Flächenvergrößerungsmittel abschließen, sodass in den Strömungsverhältnissen keine sprunghaften Veränderungen auftreten.

Als Material für die Flächenvergrößerungsmittel können PDMS sowie andere Silikone, Polyimid und andere Elastomere verwendet werden, die elastisch genug sind, die Substrate randlos zu umschmiegen.

In weiteren Ausführungsformen können für die Flächenvergrößerungsmittel faserverstärkte Materialien verwendet werden, insbesondere können die radialen Festigkeiten, Schubfestigkeiten sowie Scherfestigkeiten, welche die Flächenvergrößerungsmittel an die Substrate schmiegen, von der Materialelastizität als konzentrische, lineare Dehnung der Elastomere entkoppelt werden.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine erste erfindungsgemäße Vorrichtung,
- Figur 2a: eine zweite erfindungsgemäße Vorrichtung in einem ersten Prozessschritt,
- Figur 2b: die zweite erfindungsgemäße Vorrichtung in einem zweiten Prozessschritt,
- Figur 2c: die zweite erfindungsgemäße Vorrichtung in einem dritten Prozessschritt,
- Figur 2d: die zweite erfindungsgemäße Vorrichtung in einem vierten Prozessschritt,
- Figur 2e: die zweite erfindungsgemäße Vorrichtung in einem fünften Prozessschritt sowie ein Druck-Temperatur-Diagramm,
- Figur 3a: ein allgemeines Inversionsdiagramm,
- Figur 3b: die Inversionsdiagramme für Stickstoff, Wasserstoff und Helium,
- Figur 4a: eine schematische, nicht maßstabsgetreue Darstellung einer Substratperipherie mit einer ersten Defektart;
- Figur 4b: eine schematische, nicht maßstabsgetreue Darstellung einer Substratperipherie mit einer zweiten Defektart;
- Figur 4c: eine schematische, nicht maßstabsgetreue Darstellung einer Substratperipherie mit einer dritten Defektart;
- Figur 4d: eine schematische, nicht maßstabsgetreue Darstellung einer Substratperipherie mit einer vierten Defektart;
- Figur 4e: eine schematische, nicht maßstabsgetreue Darstellung einer Substratperipherie mit einer fünften Defektart;
- Figur 5a: eine schematische, nicht maßstabsgetreue Darstellung einer alternativen Ausführungsform für die Erweiterungsoberfläche,
- Figur 5b: eine schematische, nicht maßstabsgetreue Darstellung einer weiteren alternativen Ausführungsform für die Erweiterungsoberfläche,
- Figur 5c: eine schematische, nicht maßstabsgetreue Darstellung einer weiteren alternativen Ausführungsform für die Erweiterungsoberfläche,
- Figur 5d: eine schematische, nicht maßstabsgetreue Darstellung einer weiteren alternativen Ausführungsform für die Erweiterungsoberfläche,
- Figur 6a: eine schematische, nicht maßstabsgetreue, vergrößerte, Ansicht eines rechten Teils eines weiteren Substrathalters,
- Figur 6b: schematische, nicht maßstabsgetreue, vergrößerte, Ansicht eines rechten Teils eines weiteren Substrathalters,
- Figur 6c: schematische, nicht maßstabsgetreue, vergrößerte, Ansicht eines rechten Teils eines weiteren Substrathalters,
- Figur 6d: schematische, nicht maßstabsgetreue, vergrößerte, Ansicht eines rechten Teils eines weiteren Substrathalters,
- Figur 6e: schematische, nicht maßstabsgetreue, vergrößerte, Ansicht eines rechten Teils eines weiteren Substrathalters,
- Figur 7: eine schematische, nicht maßstabsgetreue Darstellung einer weiteren Ausführungsform und
- Figur 8: eine schematische, nicht maßstabsgetreue Darstellung einer weiteren Ausführungsform.

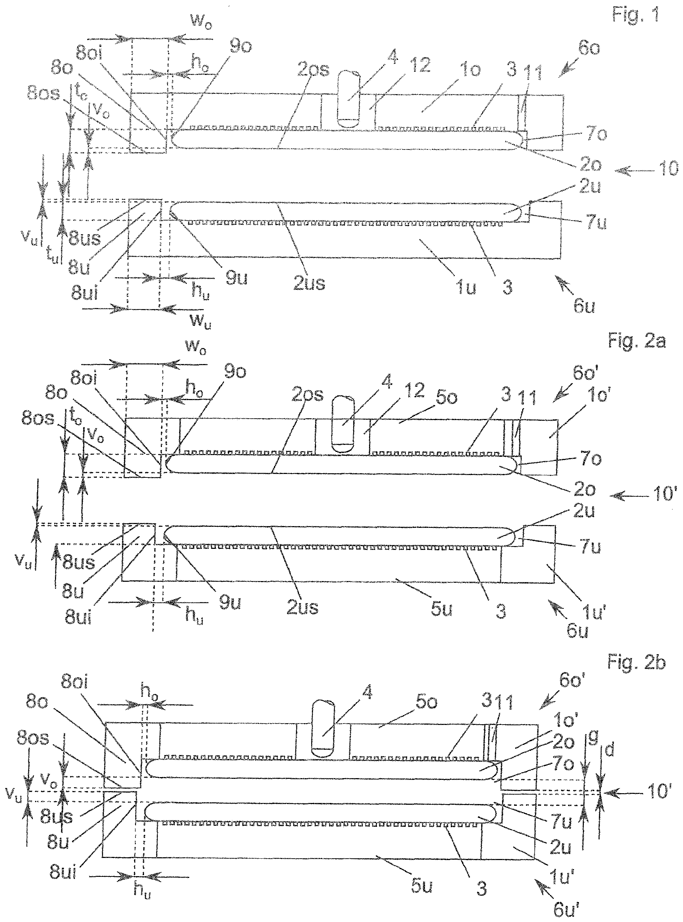

Die Figur 1 zeigt eine schematische, nicht maßstabsgetreue erste erfindungsgemäße Vorrichtung 10, bestehend aus einem ersten, unteren Substrathalter 6u, und einem zweiten, oberen Substrathalter 6o. Die beiden Substrathalter 6u, 6o bestehen aus mindestens einem ersten Bauteil 1u, 1o. Auf den Bauteilen 1u, 1o befinden sich Fixierelemente 3, welche der Fixierung von Substraten 2u, 2o dienen. Im oberen Bauteil 1o befindet sich mit Vorzug eine Öffnung 12, durch welche sich ein Verformelement 4 bewegen kann.

Das Verformelement 4 dient der Verformung des zweiten, oberen Substrats 2o. Erfindungsgemäß sind die Bauteile 1o, 1u so konstruiert, dass sie über Vertiefungen 7o, 7u verfügen, in denen sich die Substrate 2u, 2o befinden. Der Rand der ersten Bauteile 1u, 1o besteht aus Erhöhungen 8u, 8o.

Die Erhöhungen 8u, 8o besitzen Innenwände 8ui, 8oi. Die Innenwände 8ui, 8oi haben eine Höhe tu, to. Die horizontalen Abstände zwischen den Innenwänden 8ui, 8oi und Peripherien 9u, 9o der Substrate 2u, 2o betragen hu, ho. Des Weiteren verfügen die Erhöhungen 8u, 8o über eine erfindungsgemäße Erweiterungsoberfläche 8us, 8os mit einer Länge wu, wo, welche die Substratoberflächen 2us, 2os für den Gastransport über die Peripherien 9u, 9o hinaus erweitern.

Dadurch wird erfindungsgemäß bewirkt, dass der isenthalpische Expansionsprozess außerhalb der erfindungsgemäßen Vorrichtung 10 und nicht direkt außerhalb der Substrate 1u, 1o stattfindet. Das Problem wird also über die Erweiterungsoberfläche 8us, 8os nach außen verlagert.

Die vertikalen Abstände zwischen den Erweiterungsoberflächen 8us, 8os und den Substratoberflächen 2us, 2os der Substrate 2u, 2o betragen vu, vo. In dieser erfindungsgemäßen Ausführungsform sind die Geometrien fix vorgegeben und können nicht verändert werden. Die Abstände hu, ho, vu, vo wurden absichtlich zu groß dargestellt um die Übersichtlichkeit zu erhöhen. In realen Ausführungsformen dürften sie nur einige wenige µm, insbesondere bis zu max. 1.0 mm, groß sein.

Die Figur 2a zeigt eine schematische, nicht maßstabsgetreue, verbesserte zweite erfindungsgemäße Vorrichtung 10' in einem ersten erfindungsgemäßen Prozessschritt, welche aus mindestens zwei Bauteilen 1u', 5u an der Unterseite und/oder zwei Bauteilen 1o', 5o an der Oberseite besteht. Denkbar ist also auch, dass einer der beiden Substrathalter 6u', 6o` so konstruiert ist wie die Substrathalter 6u, 6o aus Figur 1. Der Einfachheit halber wird nur der untere Substrathalter 6u' beschrieben werden.

Der untere Substrathalter 6u' verfügt über ein erstes, äußeres Bauteil 1u', in dem sich ein inneres, zweites Bauteil 5u translatorisch und/oder rotatorisch bewegen kann. Die relative Verschiebung beider Bauteile 1u' und 5u dient der Positionierung der Substratoberfläche 2us in Bezug zur Erweiterungsoberfläche 8us. Erfindungsgemäß soll das austretende Gas bzw. die austretende Gasmischung über die Erweiterungsoberfläche 8us aus der erfindungsgemäßen Vorrichtung 10' geleitet werden, damit der isenthalpische Expansionsprozess nicht direkt an den Substratperipherien 9u, 9o stattfindet und so eine Kondensation von Gasen, insbesondere Wasserdampf, durch Temperaturabfall verhindert wird. Im Gegensatz zur ersten erfindungsgemäßen Vorrichtung 10 kann die Position der Substratoberfläche 2us in Bezug zur Erweiterungsoberfläche 8us aber exakt eingestellt und somit der Fluidstrom nach außen optimiert werden. Für den oberen Substrathalter 6o` gelten analoge Überlegungen.

Die Figur 2b zeigt die schematische, nicht maßstabsgetreue, verbesserte zweite erfindungsgemäße Ausführungsform 10' in einem zweiten erfindungsgemäßen Prozessschritt, bei dem die beiden Substrathalter 1u', 1o' so einander angenähert wurden, dass sich ein Erweiterungsoberflächenabstand d ergibt. Gleichzeitig existiert ein Substratoberflächenabstand g (engl.: gap).

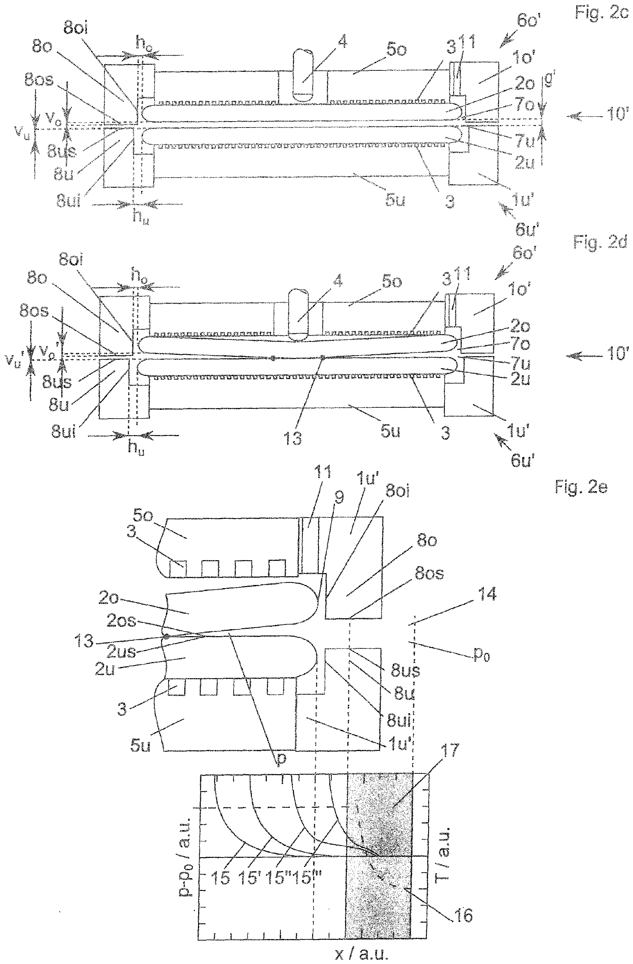

Die Figur 2c zeigt die schematische, nicht maßstabsgetreue, verbesserte zweite erfindungsgemäße Ausführungsform 10' in einem dritten erfindungsgemäßen Prozessschritt, bei dem sich die beiden zweiten Bauteile 5u, 5o translatorisch so bewegen, dass sich der Substratoberflächenabstand g auf g' verringert. Denkbar wäre auch, dass der gewünschte Substratoberflächenabstand g bereits in Figur 2b erreicht wurde, womit der dritte erfindungsgemäße Prozessschritt optionale wäre, sofern man auf die Optimierung der vertikalen Abstände vu, vo verzichten kann.

Die Figur 2d zeigt die schematische, nicht maßstabsgetreue, verbesserte zweite erfindungsgemäße Ausführungsform 10' in einem vierten erfindungsgemäßen Prozessschritt, bei dem das Verformungselement 4 das obere Substrat 2o verformt und so den Bondprozess startet. Das obere Substrat 2o wird, insbesondere durch ein gesteuertes Ausschalten der Fixierelemente 3, vom oberen Substrathalter 6o` gelöst. Ab diesem Zeitpunkt bildet sich eine, insbesondere vollumfängliche, symmetrische, Bondwelle 13 aus, welche vor sich ein komprimiertes Gas hertreibt.

Die Figur 2e zeigt eine schematische, nicht maßstabsgetreue, vergrößerte Darstellung eines seitlichen Teils der verbesserten erfindungsgemäßen Ausführungsform 10' in einem fünften erfindungsgemäßen Prozessschritt, sowie ein Druck (bzw. Druckdifferenz) -Temperatur-Positionsdiagramm.

In diesem Prozessschritt wurden die beiden Substrate 2u, 2o beinahe vollständig miteinander verbondet, mit Ausnahme der erfindungsgemäß relevanten Randbereiche der Substrate 2u, 2o. Das, von der Bondwelle 13 verdrängte Gas kann sich über die Erweiterungsflächen 8us, 8os ohne eine isenthalpe Expansion bis in den Außenbereich 14 ausbreiten.

Erst in der Nähe des Außenbereichs 14 kommt es zur isenthalpen Expansion, die bei negativem JTK zu einer Abkühlung und Kondensation des Gases geführt hätte. Durch die Erweiterung der Substratoberflächen 2us, 2os über die Erweiterungsoberflächen 8us, 8os konnte somit die isenthalpische Expansion geometrisch verzögert werden.

Im Diagramm wird auf der linken Abszisse die Druckdifferenz p-p0 aufgetragen. Bei dem Druck p0 handelt es sich um den Umgebungsdruck im Außenbereich p0. Der Umgebungsdruck p0 entspricht meistens 1 bar. Im Allgemeinen kann aber die erfindungsgemäße Ausführungsform selbst in einer Druckkammer installiert sein, in der ein erhöhter Umgebungsdruck eingestellt werden kann. Im Allgemeinen ist der Umgebungsdruck p0 kleiner als 10 bar, vorzugsweise kleiner als 5 bar, noch bevorzugter kleiner als 3 bar, am bevorzugtesten kleiner als 2 bar, am allerbevorzugtesten 1 bar.

Der Druck p repräsentiert den Druck an der angegebenen Position. Die Druckwerte p liegen im Bereich zwischen 20 bar und p0, vorzugsweise zwischen 10 bar und p0, noch bevorzugter zwischen 5 bar und p0, am bevorzugtesten zwischen 3 bar und p0, am allerbevorzugtesten zwischen 2 bar und p0.

Die unterschiedlichen Druckkurven 15, 15', 15", 15‴ repräsentieren den Druckverlauf zu vier unterschiedlich weit fortgeschrittenen Bondschritten. Die Figur 2e korreliert mit dem ersten Druckverlauf 15. Der Druckverlauf 15‴ ergibt sich beispielsweise zu einem Zeitpunkt, in dem die beiden Substratoberflächen 2us, 2os schon vollständig miteinander verbondet wurden.

Zwar liegen die Druckkurven 15, 15' und teilweise 15" noch zwischen den Substraten, allerdings findet hier noch keine isenthalpische Expansion, sondern nur die Kompression des Gases statt.

Der Bereich der isenthalpen Expansion befindet sich vorteilhaft im schattierten Beriech 17, also auf alle Fälle außerhalb der Substrate 2u, 2o. In diesem Bereich kann ein ausgestoßenes Gas ohne weiteres kondensieren, da es sich nicht mehr auf den Substratoberflächen 2us, 2os befindet. Man erkennt, dass sich die Druckkurve 15‴ außerhalb der Substrate 2u, 2o befindet, im Gegensatz zur Figur 2 der zitierten Druckschrift Castex et al., Mechanism of Edge Bonding Void Formation in Hydrophilie Direct, ECS Solid State Letters, 2 (6) P47-P50 (2013*).*

Durch die Bohrung 11 kann zusätzlich eine Evakuierung und/oder eine Spülung des Innenraums der erfindungsgemäßen Ausführungsform 10' vorgenommen werden, welcher den negativen Effekt weiter reduziert. So ist die Verwendung eines Gases denkbar, welches den JTK des Gasgemisches zwischen den beiden Substrate 2u, 2o so verändert, dass es bei der isenthalpen Expansion zu einer Erwärmung anstatt einer Abkühlung kommt.

In allen gezeigten Figuren sind geneigte Innenwände 8ui, 8oi der Erhöhungen 8u, 8o denkbar, welche das Laden der Substrate 2u, 2o erleichtern. Die Vertiefung 7u, 7o hätte dann die Form eines Kegelstumpfes.

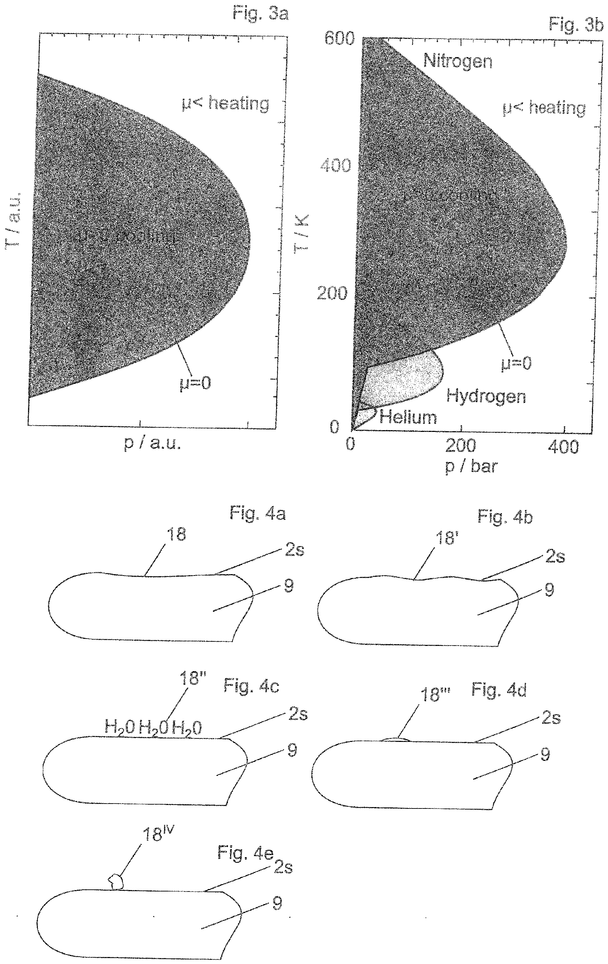

Die Figur 3a zeigt ein schematisches Diagramm einer Inversionskurve eines beliebigen Gases bzw. Gasgemisches. Erkennbar sind die Bereiche mit positivem JTK (grau) und jene mit negativem JTK (weiß). Bei dem Diagramm handelt es sich um ein p-T Diagramm.

Das betrachtete Gas besitzt also abhängig vom vorhandenen Druck und von der vorhandenen Temperatur einen positiven oder negativen JTK. Würden die Zustandsparameter Druck und Temperatur genau auf der Inversionskurve liegen, wäre der JTK null. Für ideale Gase und Gasgemische ist der JTK immer null. Es werden daher nur reale Gase bzw. Gasgemische betrachtet. Um eine erfindungsgemäße Erwärmung eines Gases bzw. eines Gasgemisches zu erzeugen muss dafür gesorgt werden, dass sich das Gas bzw. Gasgemisch immer im Bereich mit einem negativen JTK befindet. Bei Standardnormalbedingungen existieren nur drei Gase, welche einen negativen JTK besitzen, nämlich Helium, Wasserstoff und Neon.

Die Figur 3b zeigt ein schematisches Diagramm der Inversionskurven von Stickstoff, Wasserstoff und Helium. Erkennbar ist, dass für Standardnormalbedingungen (ca. 298,15K, 1 bar), Stickstoff einen positiven JTK besitzt und daher bei einer isenthalpen Expansion abkühlen wird. Es ist daher auch ein weiterer erfindungsgemäßer Aspekt, bei dem erfindungsgemäßen Bondprozess Maßnahmen zu ergreifen, um Gase, insbesondere den Luftstickstoff, mit einem positiven JTK möglichst aus der Atmosphäre zu entfernen und, vorzugsweise, gänzlich durch Gase mit positivem JTK zu ersetzen. Die beiden Gase Wasserstoff und Helium hingegen besitzen Inversionskurven, die weit unterhalb der 298, 15K liegen. Wasserstoff und Helium werden sich daher bei einer isenthalpen Expansion unter Standardnormalbedingungen erwärmen und wirken so einer Kondensation anderer Gase, insbesondere Wasserdampf, entgegen.

Die Figur 4a zeigt eine schematische, nicht maßstabsgetreue Darstellung einer Substratperipherie 9 mit einer ersten Defektart 18. Die erste Defektart 18 stellt eine Delle dar.

Die Figur 4b zeigt eine schematische, nicht maßstabsgetreue Darstellung einer Substratperipherie 9 mit einer zweiten Defektart 18'. Die zweite Defektart 18' stellt eine Substratoberfläche 2s mit hoher Oberflächenrauhigkeit dar.

Die Figur 4c zeigt eine schematische, nicht maßstabsgetreue Darstellung einer Substratperipherie 9 mit einer Substratoberfläche 2s, auf der sich adsorbierte Gase, insbesondere Wasser, befinden. Dieser Zustand stellt eigentlich den Normalzustand der meisten Oberflächen dar. In Bezug auf den erfindungsgemäßen Prozess wird dieser Zustand dennoch als dritte Defektart 18" klassifiziert. Die dritte Defektart 18" stellt also eine Substratoberfläche 2s mit adsorbierten Gasen, insbesondere Wasser dar. Das Wasser ist insbesondere nur als Monolage vorhanden.

Die Figur 4d zeigt eine schematische, nicht maßstabsgetreue Darstellung einer Substratperipherie 9 mit einer vierten Defektart 18‴. Die vierte Defektart 18‴ stellt eine Substratoberfläche 2s mit einem lokal konzentrierten, kondensierten Gas, insbesondere Wasser dar.

Die Figur 4e zeigt eine schematische, nicht maßstabsgetreue Darstellung einer Substratperipherie 9 mit einer fünften Defektart 18IV. Die fünfte Defektart 18IV stellt eine Substratoberfläche 2s mit einem Partikel dar.

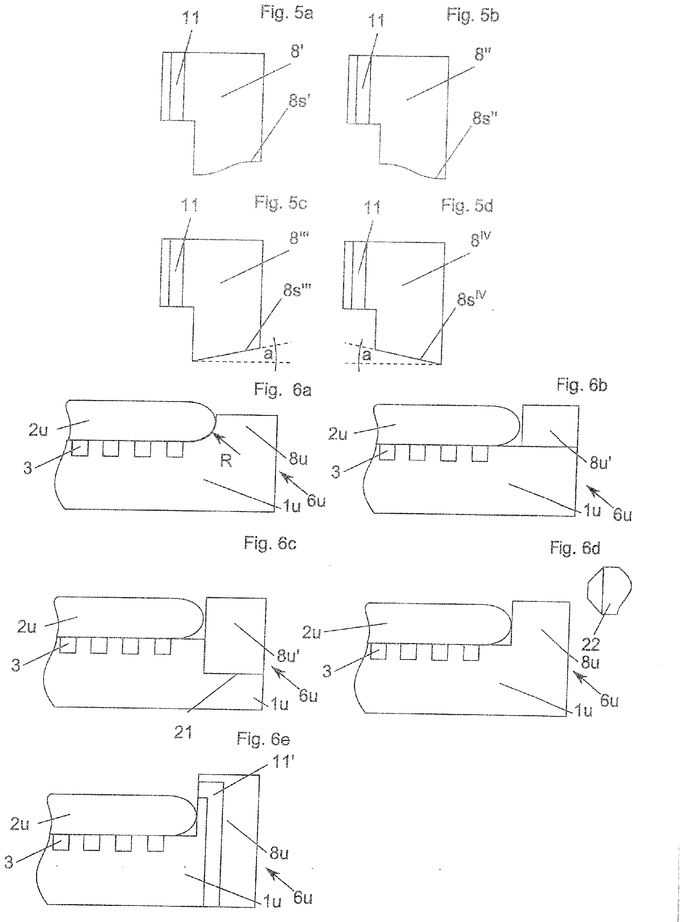

Die Figur 5a zeigt eine erste erfindungsgemäße Erweiterung der Erhöhung 8' mit einer gekrümmten Erweiterungsoberfläche 8s', die das Volumen nach außen hin vergrößert.

Die Figur 5b zeigt eine zweite erfindungsgemäße Erweiterung der Erhöhung 8" mit einer gekrümmten Erweiterungsoberfläche 8s", die das Volumen nach außen hin verkleinert. Dieses Element wirkt thermodynamisch wie ein Drosselventil.

Die Figur 5c zeigt eine dritte erfindungsgemäße Erweiterung der Erhöhung 8‴ mit einer gekrümmten Erweiterungsoberfläche 8s‴, die das Volumen nach außen hin linear vergrößert.

Die Figur 5d zeigt eine zweite erfindungsgemäße Erweiterung der Erhöhung 8IV mit einer gekrümmten Erweiterungsoberfläche 8sIV, die das Volumen nach außen hin linear verkleinert. Dieses Element wirkt thermodynamisch wie ein Drosselventil.

Die Figur 6a zeigt eine schematische, nicht maßstabsgetreue, vergrößerte, Ansicht eines rechten Teils eines verbesserten Substrathalters 6u, bei dem auf die Erzeugung von den konstruktionstechnischen Merkmalen hu, vu durch die Einführung eines abgerundeten Krümmungs- bzw. Schmiegeradius R verzichtet wurde. Die Herstellung eines solchen Übergangs ist konstruktionstechnisch um einiges leichter und effizienter.

Der Krümmungs- bzw. Schmiegeradius R ist insbesondere gleich dem Krümmungsradius der Substratperipherie 9. Der Fachmann auf dem Gebiet weiß, dass die Substratperipherien 9 im Querschnitt nach SEMI Standard nicht notwendigerweise einen Halbkreis beschreiben, sondern beliebig geformt sein können. Es wird daher, der Vollständigkeit halber erwähnt, dass der Krümmungs- bzw. Schmiegeradius R ein Parameter ist, mit dessen Hilfe man bestmöglich versucht, das Substrat 2u, insbesondere dessen Substratperipherie 9, an den unteren Substrathalter 6u anzupassen.

Für einen oberen Substrathalter 6o gelten analoge Überlegungen, sofern notwendig und gewollt. Die Abweichung zwischen dem Krümmungs- bzw. Schmiegeradius R und der Krümmung der Substratperipherie 9 ist insbesondere kleiner als 5%, vorzugsweise kleiner als 3%, noch bevorzugter kleiner als 2%, am bevorzugtesten kleiner als 1%, am allerbevorzugtesten kleiner als 0.1%. Die Verwendung eines Krümmungs- bzw. Schmiegeradius R kann mit der Verwendung der Abstände hu, ho, vu, vo kombiniert werden.

Die Figur 6b zeigt eine schematische, nicht maßstabsgetreue, vergrößerte, Ansicht eines rechten Teils eines weiteren, verbesserten Substrathalters 6u, bei dem die Erhöhung 8u' als Ring ausgeführt wurde, der auf dem Bauteil 1u montiert wird. Die Montierung wird hierbei nicht näher ausgeführt. 8u' kann mit dem Bauteil 1u verschweißt, verklebt, gebondet, verschraubt vernietet etc. werden.

Die Figur 6c zeigt eine schematische, nicht maßstabsgetreue, vergrößerte, Ansicht eines rechten Teils eines weiteren, verbesserten Substrathalters 6u, bei dem die Erhöhung 8u' als Ring ausgeführt wurde, der in auf einer Abstufung 21 des Bauteils 1u montiert wird. Die Montierung wird hierbei nicht näher ausgeführt. 8u' kann mit dem Bauteil 1u verschweißt, verklebt, gebondet, verschraubt vernietet etc. werden.

Die als Ringe ausgeführten Erhöhungen 8u' in den Figuren 6b und 6c sind vorzugsweise auch austauschbar. Damit können mehrere unterschiedliche Ringe 8u' konstruiert und bei Notwendigkeit ausgetauscht werden, um die Erhöhungen 8u' entsprechend anzupassen und für den Prozess zu optimieren.

Die Figur 6d zeigt eine schematische, nicht maßstabsgetreuc, vergrößerte, Ansicht eines rechten Teils eines weiteren, verbesserten Substrathalters 6u, bei dem eine Düse 22 von außen für die Erzeugung eines Überdrucks sorgt. Derartige Düsensysteme wurden teilweise auch bereits in der Druckschrift PCT/EP2016053268 erwähnt.

Die Figur 6e zeigt eine schematische, nicht maßstabsgetreue, vergrößerte, Ansicht eines rechten Teils eines weiteren, verbesserten Substrathalters 6u, bei dem die Bohrung 11' so konstruiert wurde, dass das Gas bzw. Gasgemisch direkt in Richtung des Substrats gespült werden kann.

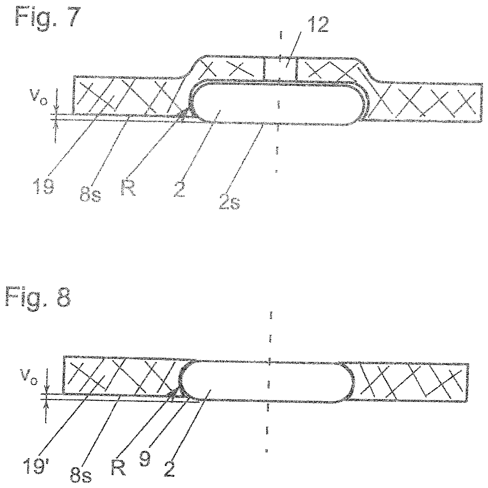

Fig. 7 zeigt eine nicht maßstabgetreue Ausführungsform einer ersten Ausführungsform eines Flächenvergrößerungsmittels 19. Dabei wird ein Substrat 2 mittels Krümmungs- sowie Schmiegeradius R des Flächenvergrößerungsmittels 19 umschlossen. Zwischen der zu bondenden Substratoberfläche 2s und einer Erweiterungsfläche 8s des Flächenvergrößerungsmittel 19 existiert ein vertikaler Abstand vo, welche bevorzugt kleiner als 10 Mikrometer, besonders bevorzugt kleiner 1 Mikrometer ist. Die Substratoberfläche 2s wird durch die Erweiterungsfläche 8s erweitert.

Die Figur 8 zeigt eine weitere nicht maßstabsgetreue Ausführungsform eines Flächenvergrößerungsmittels 19'. Dabei wird im Vergleich zu Fig. 7 das Substrat 2 lediglich an der äußeren Substratperipherie 9 gestützt, bevorzugt mit einer geringen Anpresskraft geschmiegt. Das Substrat 2 wird dabei vollumfänglich umschlossen. Das Schmiegeradius R soll die äußere Substratperipherie 9 insbesondere perfekt umschmiegen.

In den Figuren sind gleiche Bauteile oder Bauteile mit der gleichen Funktion mit den gleichen Bezugszeichen gekennzeichnet.

### Bezugszeichenliste

- 1, 1u, 1o: Erstes/äußeres Bauteil
- 2, 2u, 2o: Substrate
- 2s, 2us, 2os: Substratoberfläche
- 3: Fixierungen
- 4: Verformelement
- 5u, 5o: Zweites/inneres Bauteil
- 6u,6u',6o,6o': Substrathalter
- 7o, 7u: Vertiefung
- 8o, 8u, 8u', 8, 8', 8", 8‴, 8IV, 8V: Erhöhung
- 8oi, 8ui: Innenwand
- 8os, 8us, 8s, 8S'8s",8s‴8sIV: Erweiterungsoberfläche
- 9, 9u, 9o: Substratperipherie
- 10, 10': Bondvorrichtung
- 11, 11': Bohrung
- 12: Öffnung
- 13: Bondwelle
- 14: Außenbereich
- 15, 15', 15", 15‴: Druckkurve
- 16: Temperaturkurve
- 17: Bereich der isenthalpischen Expansion
- 18, 18', 18", 18‴, 18I^{V}: Defekt
- 19, 19': Flächenvergrößerungsmittel
- 20: Rundung
- 21: Abstufung
- 22: Düse
- a: Winkel
- d: Erweiterungsoberflächenabstand
- g: Substratoberflächenabstand
- wu, wo: Erhöhungsweite
- tu, to: Erhöhungstiefe
- ho, hu: Horizontale Abstände
- vo, vo', vu, vu': Vertikale Abstände
- p: Druck zwischen den Substraten
- p0: Umgebungsdruck
- R: Krümmungs- bzw. Schmiegeradius

## Patentansprüche

1. Vorrichtung (10, 10') zum Bonden einer ersten Substratoberfläche (2os) eines ersten Substrats (2o) mit einer zweiten Substratoberfläche (2us) eines zweiten Substrats (2u) mit:
- einem ersten Substrathalter (6o, 6o') zur Aufnahme des ersten Substrats (2o),
- einem zweiten Substrathalter (6u, 6u') zur Aufnahme des zweiten Substrats (2u),
**dadurch gekennzeichnet, dass**
zumindest der erste Substrathalter (6o, 6o') eine erste Vertiefung (7o) mit einer Fixiereinrichtung (3) zur Fixierung des ersten Substrats (2o) in der ersten Vertiefung (7o) sowie eine die Vertiefung (7o) zumindest teilweise umgebende Erhöhung (8o) aufweist;
wobei die Vorrichtung (10, 10') eine Bohrung (11) zur Evakuierung und/oder Spülung der ersten Vertiefung (7o) aufweist, wobei die erste Vertiefung (7o) mit einem Gas und/oder einer Gasmischung mit einem negativen Joule-Thompson Koeffizienten vor und/oder während und/oder nach dem Bonden der Substrate (2o,2u) spülbar ist, wobei die Erhöhung (8o) eine Erweiterungsoberfläche (8os) zur nahtlosen Erweiterung der ersten Substratoberfläche (2os) aufweist.

2. Vorrichtung (10, 10') nach Anspruch 1, wobei die erste Vertiefung (7o) mit dem Gas und/oder der Gasmischung mit einem negativen Joule-Thompson Koeffizienten spülbar ist, um zumindest teilweise, vorzugsweise vollständig, ein Gas und/oder ein Gasgemisch mit einem positiven Joule-Thompson Koeffizienten zu entfernen.

3. Vorrichtung (10, 10') nach einem der vorhergehenden Ansprüche, wobei das Gas und/oder die Gasmischung mit einem negativen Joule-Thompson Koeffizienten Helium, Wasserstoff und/oder Neon aufweist.

4. Vorrichtung (10, 10') nach einem der vorhergehenden Ansprüche, wobei das Gas und/oder das Gasgemisch mit einem positiven Joule-Thompson Koeffizienten Stickstoff aufweist.

5. Vorrichtung (10, 10') nach einem der vorhergehenden Ansprüche, wobei die Vertiefung (7o) und/oder die Erhöhung (8o) derart an das erste Substrat (2o), insbesondere an die Form des ersten Substrats (2o), angepasst ist/sind, dass die Substratoberfläche (2os) mit der Erweiterungsoberfläche (8os) eine im Wesentlichen durchgehende Oberfläche bildet und/oder in die Erhöhung (8o) übergeht.

6. Vorrichtung (10, 10') nach einem der vorhergehenden Ansprüche, wobei die Vertiefung (7o) und/oder die Erhöhung (8o) manuell und/oder halbautomatisch und/oder automatisch derart anpassbar ist/sind, dass die Substratoberfläche (2os) mit der Erweiterungsoberfläche (8os) eine im Wesentlichen durchgehende Oberfläche bildet und/oder in die Erhöhung (8o) übergeht.

7. Vorrichtung (10, 10') nach einem der vorhergehenden Ansprüche, wobei der erste Substrathalter (6o, 6o') ein äußeres Bauteil 1o') und ein im äußeren Bauteil 1o') bewegliches inneres Bauteil (5o) aufweist, wobei das äußere und/oder innere Bauteil (5o) translatorisch und/oder rotatorisch beweglich ist, wobei die Bauteile (1o', 5o) zueinander fixierbar sind.

8. Vorrichtung (10, 10') nach einem der vorhergehenden Ansprüche, wobei der vertikale Abstand (vo, vu) zwischen der ersten Substratoberfläche (2os) und der Erweiterungsoberfläche (8os) anpassbar ist.

9. Vorrichtung (10, 10') nach einem der vorhergehenden Ansprüche, aufweisend mindestens eine Bohrung (11) zur Evakuierung und/oder Spülung der Vertiefung (7o), wobei bevorzugt mehrere Bohrungen (11) symmetrisch verteilt, insbesondere im inneren Bauteil (10'), angeordnet sind.

10. Vorrichtung (10, 10') nach einem der vorhergehenden Ansprüche, wobei die Erhöhung (80, 8', 8") eine nach innen und/oder außen hin gekrümmte Erweiterungsoberfläche (80, 8s', 8s") aufweist.

11. Vorrichtung (10, 10') nach einem der vorhergehenden Ansprüche, wobei die Erhöhung (80, 8‴, 8IV) eine nach innen und/oder außen hin in einem Winkel (a) abgeschrägte Erweiterungsoberfläche (8o, 8s‴, 8sIV) aufweist.

12. System aus einer Vorrichtung (10, 10') gemäß einem der vorhergehenden Ansprüche und dem ersten Substrat (2o), **dadurch gekennzeichnet, dass** die erste Substratoberfläche (2os) in die Erhöhung (8o) übergeht.

13. Verfahren zum Bonden einer ersten Substratoberfläche (2os) eines ersten Substrats (2o) mit einer zweiten Substratoberfläche (2us) eines zweiten Substrats (2u) mittels einer Vorrichtung (10, 10') gemäß einem der vorhergehenden Ansprüche, wobei ein zwischen den Substratoberflächen (2os, 2us) beim Bondvorgang angeordnetes Gas von einem Zentrum zum Rand (9, 9o, 9u) der Substrate (2o, 2u) hin verdrängt wird,
2. wobei zumindest die erste Substratoberfläche (2os) in die Erhöhung (8o) derart übergeht, dass eine Expansion des Gases erst außerhalb der Substrate (2o, 2u) erfolgt, wobei die erste Vertiefung (7o) mit einem Gas und/oder einer Gasmischung mit einem negativen Joule-Thompson Koeffizienten vor und/oder während und/oder nach dem Bonden der Substrate (2o,2u) gespült wird.

## Claims

1. Apparatus (10, 10') for bonding a first substrate surface (2os) of a first substrate (2o) to a second substrate surface (2us) of a second substrate (2u), with:
- a first substrate holder (6o, 6o') for receiving the first substrate (2o),
- a second substrate holder (6u, 6u') for receiving a second substrate (2u),
**characterized in that**
at least the first substrate holder (6o, 6o') has a first recess (7o) with a securing device (3) for securing the first substrate (2o) within the first recess, and a raised portion (8o) at least partly surrounding the recess (7o):
wherein the apparatus (10, 10') has a hole (11) for evacuating and/or flushing the first recess (7o), wherein the first recess (7o) can be flushed with a gas and/or a gas mixture having a negative Joule-Thompson coefficient before and/or during and/or after bonding of the substrates (2o, 2u), wherein the raised portion (8o) has an expansion surface (8os) for seamless expansion of the first substrate surface (2os).

2. Apparatus (10, 10') according to Claim 1, wherein the first recess (7o) can be flushed with the gas and/or the gas mixture having a negative Joule-Thompson coefficient in order to at least partially, preferably completely remove a gas and/or a gas mixture that has a positive Joule-Thompson coefficient.

3. Apparatus (10, 10') according to any of the preceding claims, wherein the gas and/or the gas mixture having a negative Joule-Thompson coefficient includes helium, hydrogen and/or neon.

4. Apparatus (10, 10') according to any one of the preceding claims, wherein the gas and/or the gas mixture having a positive Joule-Thompson coefficient includes nitrogen.

5. Apparatus (10, 10') according to any one of the preceding claims, wherein the recess (7o) and/or the raised portion (8o) is/are adjusted to the first substrate (2o), particularly to the shape of the first substrate (2o), in such a way that the substrate surface (2os) forms a substantially continuous surface with the expansion surface (8os) and/or merges with the raised portion (8o).

6. Apparatus (10, 10') according to any one of the preceding claims, wherein the recess (7o) and/or the raised portion (8o) is/are adjustable manually and/or semiautomatically and/or automatically in such manner that the substrate surface (2os) forms a substantially continuous surface with the expansion surface (8os) and/or merges with the raised portion (8o).

7. Apparatus (10, 10') according to any one of the preceding claims, wherein the first substrate holder (6o, 6o') includes an outer part 1o') and an inner part (5o) which is movable within the outer part 1o') wherein the outer and/or inner part (5o) is movable translationally and/or rotationally, wherein the parts (1o ', 5o) can be secured to each other.

8. Apparatus (10, 10') according to any one of the preceding claims, wherein the vertical distance (vo, vu) between the first substrate surface (2os) and the expansion surface (8os) is adjustable.

9. Apparatus (10, 10') according to any one of the preceding claims, having at least one hole (11) for evacuating and/or flushing the recess (7o), wherein preferably multiple holes (11) are arranged symmetrically, particularly in the inner part (1o').

10. Apparatus (10, 10') according to any one of the preceding claims, wherein the raised portion (80, 8', 8") has an expansion surface (80, 8s', 8s") which is curved inwards and/or outwards.

11. Apparatus (10, 10') according to any one of the preceding claims, wherein the raised portion (80, 8"', 81V) has an expansion surface (80, 8s‴, 8sIV) which is chamfered inwards and/or outwards at an angle (a).

12. System comprising an apparatus (10, 10 ') according to any one of the preceding claims and the first substrate (2o), **characterized in that** the first substrate surface (2os) merges with the raised portion (8o).

13. Method for bonding a first substrate surface (2os) of a first substrate (2o) to a second substrate surface (2us) of a second substrate (2u) using an apparatus (10, 10') according to any one of the preceding claims, wherein a gas arranged between the substrate surfaces (2os, 2us) is displaced from a middle area to the peripheral area (9, 9o, 9u) of the substrates (2o, 2u) during the bonding process,
wherein
at least the first substrate surface (2os) merges into the raised portion (8o) in such manner that an expansion of the gas takes place only outside of the substrates (2o, 2u), wherein the first recess (7o) is flushed with a gas and/or gas mixture having a negative Joule-Thompson coefficient before and/or during and/or after the bonding of the substrates (2o, 2u).

## Revendications

1. Dispositif (10,10') de liaison d'une première surface de substrat (2os) d'un premier substrat (2o) à une seconde surface de substrat (2us) d'un second substrat (2u) comportant :
- un premier support de substrat (6o, 6o') destiné à recevoir le premier substrat (2o),
- un second support de substrat (6u, 6u') destiné à recevoir le second substrat (2u),
**caractérisé en ce**
**qu'**au moins le premier support de substrat (6o, 6o') présente un premier creux (7o) doté d'un dispositif de fixation (3) pour la fixation du premier substrat (2o) dans le premier creux (7o) et un rehaussement (8o) entourant au moins partiellement le creux (7o), le dispositif (10, 10') présentant un trou (11) pour évacuer et/ou rincer le premier creux (7o), le premier creux (7o) pouvant être rincé avec un gaz et/ou un mélange gazeux ayant un coefficient Joule-Thompson négatif avant ou pendant/ou après la liaison du substrat (2o, 2u), le rehaussement (8o) présentant une surface d'extension (8os) pour l'extension sans jointure de la première surface de substrat (2os).

2. Dispositif (10,10') selon la revendication 1, dans lequel le premier creux (7o) peut être rincé avec le gaz et/ou le mélange gazeux ayant un coefficient Joule-Thompson négatif pour éliminer au moins partiellement, de préférence complètement, un gaz et/ou un mélange gazeux ayant un coefficient Joule-Thompson négatif.

3. Dispositif (10,10') selon une des revendications précédentes, dans lequel le gaz et/ou le mélange gazeux ayant un coefficient Joule-Thompson négatif présente de l'hélium, de l'hydrogène et/ou du néon.

4. Dispositif (10,10') selon une des revendications précédentes, dans lequel le gaz et/ou le mélange gazeux ayant un coefficient Joule-Thompson négatif présente de l'azote.

5. Dispositif (10,10') selon une des revendications précédentes, dans lequel le creux (7o) et/ou le rehaussement (8o) est/sont adapté(s) au premier substrat (2o), en particulier à la forme du premier substrat (2o), de manière à ce que la surface de substrat (2os) forme avec la surface d'extension (8os) une surface sensiblement continue et/ou transite dans le rehaussement (8o).

6. Dispositif (10,10') selon une des revendications précédentes, dans lequel le creux (7o) et/ou le rehaussement (8o) est/sont adaptables(s) manuellement et/ou semi-automatiquement et/ou automatiquement de manière à ce que la surface de substrat (2os) forme avec la surface d'extension (8os) une surface sensiblement continue et/ou transite dans le rehaussement (8o).

7. Dispositif (10,10') selon une des revendications précédentes, dans lequel le premier support de substrat (6o, 6o') présente une pièce extérieure 1o') et une pièce intérieure (5o) mobile dans la pièce extérieure (1o'), la pièce extérieure et/ou intérieure (5o) étant mobile en translation et/ou en rotation, les pièces (1o', 5o) pouvant être fixées l'une à l'autre.

8. Dispositif (10,10') selon une des revendications précédentes, dans lequel la distance verticale (vo, vu) entre la première surface de substrat (2os) et la surface d'extension (8os) est adaptable.

9. Dispositif (10,10') selon une des revendications précédentes, présentant au moins un trou (11) pour évacuer et/ou rincer le creux (7o), plusieurs trous (11) étant de préférence disposés en étant répartis symétriquement, en particulier dans la pièce intérieure (1o').

10. Dispositif (10,10') selon une des revendications précédentes, dans lequel le rehaussement (8o, 8', 8") présente une surface d'extension (80, 8s', 8s") courbée vers l'intérieur et/ou l'extérieur.

11. Dispositif (10,10') selon une des revendications précédentes et du premier substrat (2o), dans lequel le rehaussement (8o, 8‴, 8IV) présente une surface d'extension (80, 8s‴, 8sIV) biseautée vers l'intérieur et/ou l'extérieur suivant un angle (a).

12. Système composé d'un dispositif (10,10') selon une des revendications précédentes et du premier substrat (2o), **caractérisé en ce que** la première surface de substrat (2os) transite dans le rehaussement (8o).

13. Procédé de liaison d'une première surface de substrat (2os) d'un premier substrat (2o) à une seconde surface de substrat (2us) d'un second substrat (2u) moyen d'un dispositif (10,10') selon une des revendications précédentes, dans lequel un gaz disposé entre les surfaces de substrat (2os, 2us) lors de l'opération de liaison est refoulé depuis un centre vers le bord (9, 9o, 9u) des substrats (2o, 2u),
au moins la première surface de substrat (2os) transitant dans le rehaussement (8o) de manière à ce qu'une expansion du gaz n'ait lieu qu'à l'extérieur des substrats (2o, 2u), le premier creux (7o) étant rincé avec un gaz et/ou un mélange gazeux ayant un coefficient Joule-Thompson négatif avant et/ou pendant et/ou après la liaison des substrats (2o, 2u).
